# EUROPEAN PATENT SPECIFICATION

(11) **EP 0 678 786 B1**
(45) Date of publication and mention of the grant of the patent: **17.06.1998**
(21) Application number: 95200555.1
(22) Date of filing: 07.03.1995
(51) Int. Cl.: G03F 7/07, B41N 3/08

(54) **A method for making a lithographic printing plate**
Verfahren zur Herstellung einer lithographischen Druckplatte
Procédé pour la fabrication d'une plaque d'impression lithographique

(30) Priority: 19.04.1994 EP 94201071
(43) Date of publication of application: 25.10.1995
(73) Proprietor: AGFA-GEVAERT N.V., 2640 Mortsel (BE)
(72) Inventor: Lode, Deprez, c/o Agfa-Gevaert N.V., B-2640 Mortsel (BE)

(56) References cited:
- EP-A- 0 519 123
- FR-E- 89 114
- GB-A- 2 081 183
- GB-A- 2 095 620
- US-A- 3 904 412
- US-A- 5 118 583
- DATABASE WPI Section PQ, Week 9349, Derwent Publications Ltd., London, GB; Class P84, AN 93-389414 & JP-A-5 289 341 (MITSUBISHI PAPER MILLS LTD) 5 November 1993
- DATABASE WPI Section PQ, Week 8344, Derwent Publications Ltd., London, GB; Class P84, AN 83-805350 & JP-A-58 162 392 (MITSUBISHI PAPER MILLS LTD) 27 September 1983

## Description

### 1. Field of the invention.

The present invention relates to a method for making a lithographic printing plate according to the silver salt diffusion transfer process.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. For example, typical lithographic printing plates are disclosed e.g. EP-A-423399 and EP-A-410500.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method.

As for other printing plates it is required that the printing plates obtained according to the DTR-process have a high printing endurance, good ink acceptance in the printing areas and no ink acceptance in the non-printing areas (no staining). It is furthermore desirable, especially for low printing runs, that the number of copies that have to be disposed of because of poor ink acceptance in the printing areas and/or ink acceptance in the non-printing areas during start-up of the printing process is limited. Besides the above requirements the printing plate preferably exhibits a high resolving power.

In EP 590204 it has been proposed to treat a developed monosheet DTR-material with a neutralizing solution having a pH less than 7 and containing a meso-ionic compound. A reduction in the number of copies that have to be disposed of and an increase of the resolution was found. However, the meso-ionic compounds are expensive and the achieved result is still unsatisfactory.

Neutralizing solutions having a pH around 5.6 containing cysteine have also been used to obtain the objective of decreasing the number of useless copies during startup. Although such neutralizing solutions are effective, they have a inherent low stability and need to be refreshed frequently.

Furthermore, these neutralizing solutions have a tendency to cristallization due to the presence of inorganic salts that are water-soluble only in a low or moderate concentration. The rather low or moderate neutralizing capacity of these neutralizing solutions results in a higher cost for stocking the necessary amount of these neutralizing solutions and in a need for frequent replenishment of said neutralizing solutions, what is cumbersome for the printer

### 3. Summary of the invention.

It is an object of the present invention to provide a method for making a lithographic printing plate according to the DTR-process having good printing properties i.e. good ink acceptance in the printing areas, no ink acceptance in the non-printing areas and a good resolving power using a neutralizing solution that is cheaper and less cumbersome for the printer

Further objects of the present invention will become clear from the description hereinafter.

According to the present invention there is provided a method for making a lithographic printing plate according to the silver salt diffusion transfer process comprising the steps of:
- image-wise exposing an imaging element comprising on a support a photosensitive layer comprising a silver halide emulsion and an image receiving layer containing physical development nuclei in water permeable relationship with said emulsion layer,
- developing said imaging element in the presence of developing agent(s) and silver halide solvent(s) using an alkaline processing solution and
- treating the thus obtained developed imaging element using a neutralizing solution having a pH at 25 °C between 5 and 10.5, characterized in that said neutralizing solution contains in a total concentration between 0.03 and 3 mole/l an alkanolamine that corresponds to the following formula: 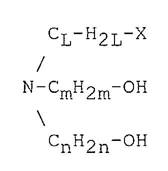 wherein X represents a hydrogen, a hydroxyl group or an amino group, L represents 0 or an integer from 1 to 4, m and n each independently represent an integer from 1 to 4.

### 4. Detailed description of the invention

It has been found that with a lithographic printing plate prepared according to the DTR-process and treated with a neutralizing solution containing one or more compounds corresponding to the above described formula the number of copies that have to be disposed of during startup can be decreased. This result can be obtained without the addition of special compounds such as a mesoionic compound or cysteine.

GB-A-2,081,183 describes a processing composition which is used for lithographic printing plates where photographically formed image silver per se or image silver halide per se is used as ink receptive area. This composition comprises an organic compound having at least one mercapto or thione group and at least one hydrophilic group in the same molecule e.g. 2-mercaptohistidine. It does however not disclose organic amines wherein at least 50 % by number of the hydrophilic groups are hydroxyls or wherein said compound is an amine containing at least two hydroxyls.

JP-A-5-289,341 discloses a processing solution for an offset plate making use of the ink-receptiveness of a silver image, which solution can contain glutamic acid or glycine. It does however not disclose organic amines wherein at least 50 % by number of the hydrophilic groups are hydroxyls or wherein said compound is an amine containing at least two hydroxyls.

US-A-3,904,412 discloses a method for the preparation of a planographic printing plate comprising a treatment with an aqueous lithographic fixer comprising organic nitrogen-containing compounds e.g. 1-ethanol-2-thione-imidazolidine. It does however not disclose organic amines wherein at least 50 % by number of the hydrophilic groups are hydroxyls or wherein said compound is an amine containing at least two hydroxyls.

Said compounds can be prepared by well known methods e.g. reaction of ammonia or an amine with the appropriate hydrocarbon halide, sulfonate, oxyde, etc. ..

Hydroxyls account preferably for at least 80 % by number, more preferably for the total of the hydrophilic groups.

According to the invention the neutralizing solution contain an alkanolamine that correspond to the following formula : 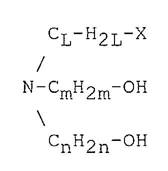 wherein X represents a hydrogen, a hydroxyl group or an amino group, L represents 0 or an integer from 1 to 4, m and n each independently represent an integer from 1 to 4. Preferred are said alkanolamines wherein m and n each independently represents 1 or 2.

Examples of compounds according to the invention are e.g. diethanolamine, N-ethyldiethanolamine, diisopropanolamine, N,N-ethyl-2,2'-iminodiethanol, triethanolamine, tri-(2-hydroxypropyl)amine, etc.

The compounds suitable for use according to the present invention can be used alone or in combination with each other. The total concentration on said compounds in the ready-for-use neutralization solution is preferably comprised between 0.1 mole/l and 1 mole/l, more preferably between 0.2 mole/l and 0.6 mole/l. Said concentration can be obtained by using an already prepared neutralization solution having such a concentration or by diluting a more concentrated stock solution comprising said compounds with water or an aqueous solution.

The neutralization solution preferably comprises a buffer, more preferably a phosphate or a citrate buffer, most preferably in an amount between 20 g/l and 80 g/l.

The neutralization solution preferably also comprises a heterocyclic compound, substituted by a mercapto or a thione group, more preferably in an amount between 0.1 and 10 g/l, most preferably in an amount between 0.3 g/l ang 3 g/l.

The pH at 25 °C of a fresh neutralization solution lies preferably between 5 and 9, more preferably between 6 and 8, but may increase during use to a value of about 10.5. The pH of a fresh neutralization solution may be adjusted by adding to the aqueous solution of (a) compound(s) suitable for use according to the present invention an organic or preferably an inorganic acid or vice versa or preferably a buffer solution.

The neutralizing solution may contains other organic amines, although this is not preferred. The solution may contain substances which influence the hydrophobic / hydrophilic balance of the printing plate obtained after processing of the DTR element, e.g. silica. Further the neutralizing solution can contain wetting agents, preferably compounds containing perfluorinated alkyl groups.

The alkaline processing solution used for developing the imaging element in accordance with the method of the present invention preferably contains a silver halide solvent. Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones, thiocyanates and thiosulfates. Further silver halide solvents that can be used in connection with the present invention are alkanolamines.

Alkanolamines that are suitable for use in accordance with the present invention may be of the tertiary, secundary or primary type. Examples of alkanolamines that may be used in connection with the present invention correspond to the following formula: 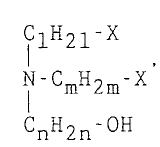 wherein X and X' independently represent hydrogen, a hydroxyl group or an amino group, l and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.

According to the present invention the alkanolamines are preferably present in the alkaline processing solution in a concentration preferably between 0.1% and 10% by weight. However part or all of the alkanolamine can be present in one or more layers of the imaging element.

A further suitable type of silver halide solvents are thioether compounds. Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain a oxygen bridge and t represents an integer from 0 to 10. Examples of thioether compounds corresponding to the above formula are disclosed in e.g. US-P-4.960.683 and EP-A-554.585.

According to the present invention the alkaline processing and/or neutralizing solution preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Preferred hydrophobizing agents are mercapto-1,3,4-thiadiazoles as described in DE-A 1,228,927 and in US-P 4,563,410, 2-mercapto-5-alkyl-oxa-3,4-diazole and long chain (at least 5 carbon atoms) alkyl substituted mercaptotetrazoles. Particularly preferred compounds are 5-n-heptyl-2-mercapto-1,3,4,-oxadiazol and 3-mercapto-4-acetamido-5-n-heptyl-1,2,4-triazole.

According to the present invention the hydrophobizing agents are contained in the alkaline processing solution or the neutralizing solution in an amount of at least 0.1g/l, more preferably at least 0.2g/l and most preferably at least 0.3g/l. The maximum amount of hydrophobizing agents will be determined by the type of hydrophobizing agent, type and amount of silver halide solvents etc.. Typically the concentration of hydrophobizing agent is preferably not more than 1.5g/l and more preferably not more than 1g/l.

According a particularly preferred embodiment in connection with the present invention the alkaline processing solution contains a meso-ionic compound as a regulating compound. Meso-ionic compounds as referred to in the present invention are a group of compounds defined by W. Baker and W.D. Ollis as "5- or 6-membered heterocyclic compounds which cannot be represented satisfactorily by any one covalent or polar structure and possesses a sextet of π-electrons in association with the atoms comprising the ring. The ring bears a fractional positive charge balanced by a corresponding negative charge located on a covalently attached atom or group of atoms" as described in Quart. Rev., Vol. 11, p. 15 (1957) and Advances in Heterocyclic Chemistry, Vol. 19, P. 4 (1976).

Preferred meso-ionic compounds for use in accordance with the present invention are triazolium thiolates and more preferably 1,2,4-triazolium-3-thiolates and most peferably those that correspond to the following formula: 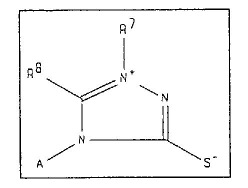 wherein R⁷ and R⁸ each independently represents an alkyl group, alkenyl group, cycloalkyl group, aralkyl group, aryl group or heterocyclic group each of which groups may be substituted or not, A represents an alkyl group, alkenyl group, cycloalkyl group, aralkyl group, aryl group, heterocyclic group each of which groups may be substituted or represents -NR⁹R¹⁰ wherein R⁹ and R¹⁰ each independently represents hydrogen, a substituted or unsubstituted alkyl group or a substituted or unsubstituted aryl group or wherein R⁷ and R⁸ or R⁸ and A or R⁹ and R¹⁰ together with the atoms to which they are attached represent the necessary atoms to form a 5- or 6-membered ring.

Specific examples of 1,2,4-triazolium-3-thiolates suitable for use in accordance with the present invention are shown in table 1.

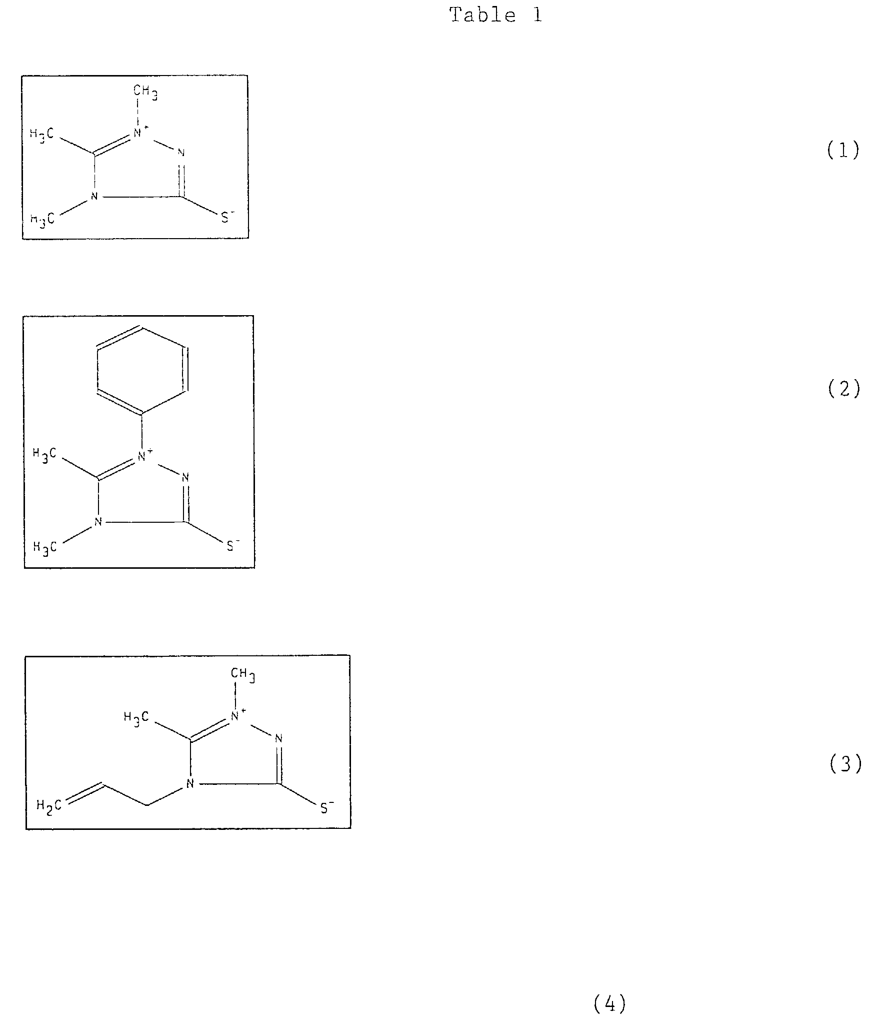

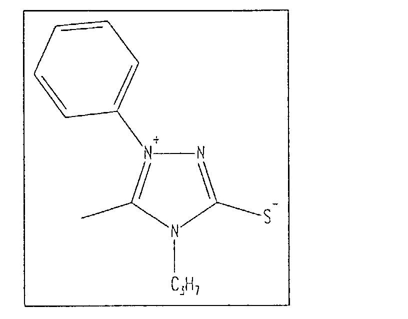

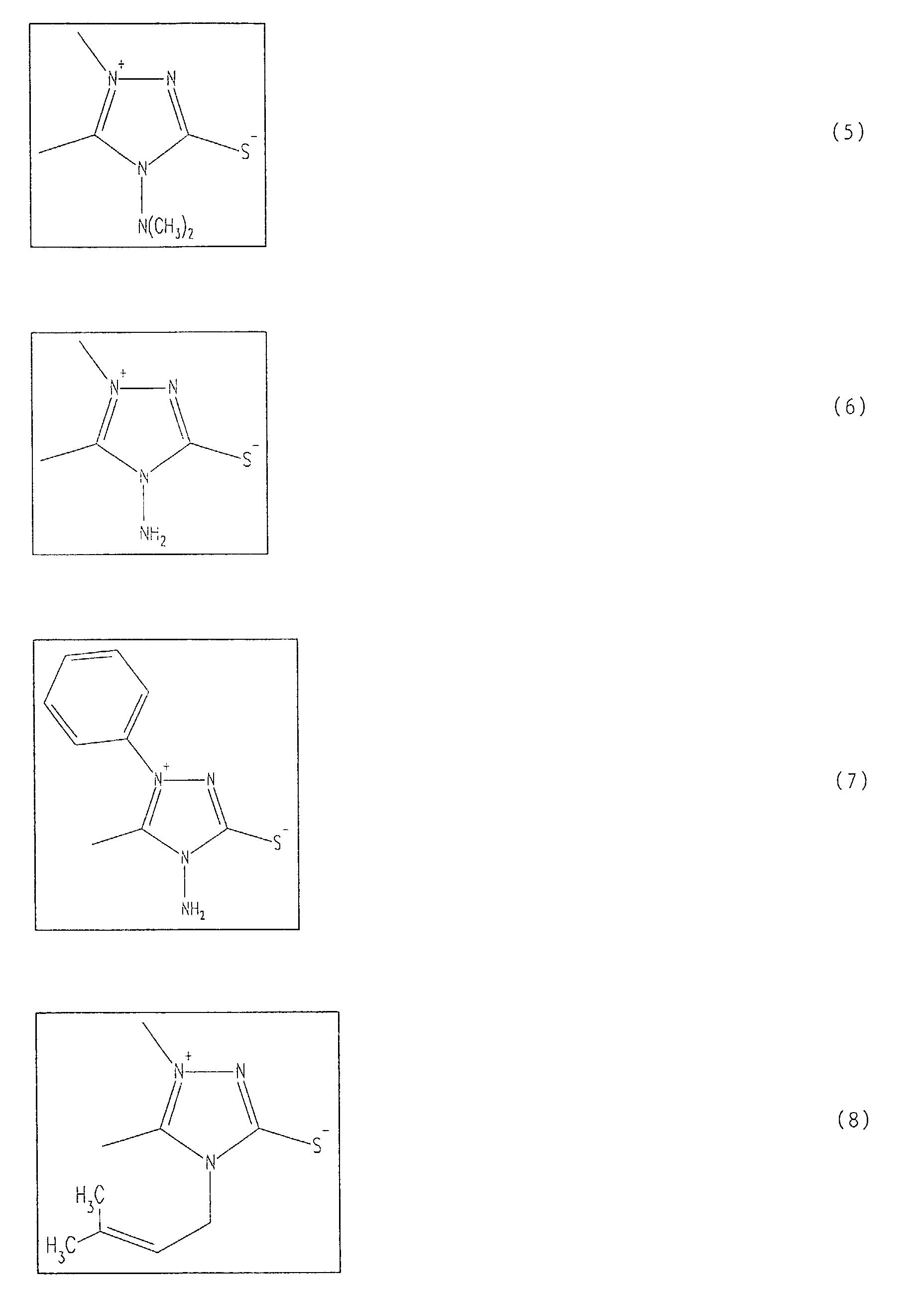

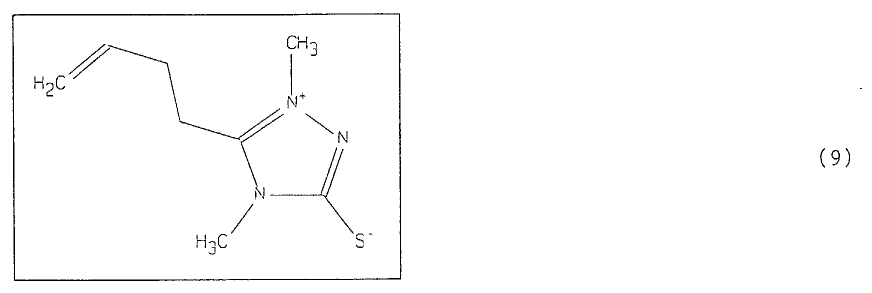

According to a preferred embodiment of the present invention at least part and most preferably all of the meso-ionic compound is preferably present in the alkaline processing solution used for developing the image-wise exposed imaging element. Preferably the amount of meso-ionic compound in the alkaline processing solution is between 0.1 mmole/l and 25 mmole/l and more preferably between 0.5 mmole/l and 15 mmole/l and most preferably between 1 mmole/l and 8 mmole/l.

However the meso-ionic compound may be incorporated in one or more layers comprised on the support of the imaging element. This offers the advantage of replenishment of said meso-ionic compound in the alkaline processing solution. Preferably the meso-ionic compound is incorporated in a layer of the imaging element that does not contain silver halide such as e.g. in a backing layer, in the image receiving layer, a subbing layer etc.. The meso-ionic compound is preferably contained in the imaging element in a total amount between 0.1 and 10mmole/m², more preferably between 0.1 and 0.5mmole/m² and most preferably between 0.5 and 1.5mmole/m².

The alkaline processing solution used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help maintain the pH and serve as a silver halide complexing agent.

The alkaline processing solution may also contain the developing agent(s) used in accordance with the present invention. In this case the alkaline processing solution is called a developer. On the other hand some or all of the developing agent(s) may be present in one or more layers of the imaging element. When all of the developing agents are contained in the imaging element the alkaline processing solution is called an activator or activating solution.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used.

The alkaline processing solution preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mole/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing solution and/or one or more layers of the photographic element, preferably polyalkylene derivatives having a molecular weight of at least 400 such as those described in e.g. US-P 3,038,805 - 4,038,075 - 4,292,400 - 4,975,354.

According to the present invention the imaging element can be information-wise exposed in an apparatus according to its particular application, e.g. a conventional process camera containing a conventional light source or a laser containing device.

The imaging element in connection with the present invention for preparing a lithographic printing plate essentially contains on a support a photosensitive layer containing silver halide and an image receiving layer containing physical development nuclei in water permeable relationship with said emulsion layer.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or complexed silver ions.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used in accordance with the present invention.

The image receiving layer containing physical development nuclei used in accordance with the present invention is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

According to the present invention the emulsion or emulsions preferably consist principally of silver chloride while a fraction of silver bromide may be present ranging from 1 mole % to 40 mole %. Most preferably a silver halide emulsion containing at least 70 mole % silver chloride is used.

The emulsion preferably belongs to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The average size of the silver halide grains may range from 0.10 to 0.70 µm , preferably from 0.25 to 0.45 µm.

Preferably during the precipitation stage Iridium and/or Rhodium containing compounds or a mixture of both are added. The concentration of these added compounds ranges from 10⁻⁸ to 10⁻³ mole per mole of AgNO₃, preferably between 0.5∗10⁻⁷ and 10⁻⁵ mole per mole of AgNO₃.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by an argon ion laser a blue sensizing dye is incorporated. In case of exposure by a red light emitting source, e.g. a LED or a HeNe laser a red sensitizing dye is used. In case of exposure by a semiconductor laser special spectral sensitizing dyes suited for the near infra-red are required. Suitable infra-red sensitizing dyes are disclosed in i.a. US-P 2.095,854, 2,095,856, 2,955,939, 3,482,978, 3,552,974, 3,573,921, 3,582,344, 3,623,881 and 3,695,888.

A preferred blue sensitizing dye, green sensitizing dye, red sensitizing dye and infra-red sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable stabilizers are azaindenes, preferably tetra-or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value near the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787, DE-P 2,453,217.

More details about the composition, preparation and coating of silver halide emulsions can be found in e.g. Product Licensing Index, Vol. 92, December 1971, publication 9232, p. 107-109.

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P 2,327,828. On the other hand, in order to gain sensitivety, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value near the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the vinylsulfone type e.g. methylenebis(sulfonylethylene), aldehydes e.g. formaldehyde, glyoxal, and glutaraldehyde, N-methylol compounds e.g. dimethylolurea and methyloldimethylhydantoin, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic emulsion layer or in at least one other hydrophilic colloid layer. Examples of suitable surface-active agents are described in e.g. EP 545452. Preferably compounds containing perfluorinated alkyl groups are used.

The photographic material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The present invention will now be illustrated by the following example without however limiting it thereto. All parts are by weight unless otherwise specified.

### EXAMPLE (Comparative example)

### Preparation of the silver halide emulsion coating solution.

A silver chlorobromide emulsion composed of 98.2mole% of chloride and 1.8mole% of bromide was prepared by the double jet precipitation method. The average silver halide grain size was 0.4µm (diameter of a sphere with equivalent volume) and contained Rhodium ions as internal dopant. The emulsion was orthochromatically sensitized and stabilized by a 1-phenyl-5-mercapto-tetrazole.

A base layer coating solution was prepared having the following composition:

| | |
|---|---|
| gelatin | 5.5% |
| carbon black | 0.76% |
| silica particles (5µm) | 1.6% |

### Preparation of the imaging element:

The emulsion coating solution and base layer coating solution were simultaneously coated by means of the cascade coating technique to a polyethylene terephthalate support provided with a pack of two backing layers such that the base layer coating was coated directly to the side of the support opposite to the side containing said backing layers. The emulsion layer was coated such that the silver halide coverage expressed as AgNO₃ was 1.5g/m² and the gelatin content was 1.5g/m². The emulsion layer further contained 0.15g/m² of 1-phenyl-4,4'-dimethyl-3-pyrazolidone and 0.25g/m² of hydroquinone. The base layer was coated such that the amount of gelatin in the coated layer was 3g/m².

The layer nearest to the support of the backing layer pack contained 0.3 g/m² of gelatin and 0.5 g/m² of the antistatic agent co(tetraallyloxyethane / methacrylate / acrylic acid-K-salt) polymer. The second backing layer contained 4 g/m² of gelatin, 0.15 g/m² of a matting agent consisting of transparent spherical polymeric beads of 3 micron average diameter according to EP 0080225, 0.05 g/m² of hardening agent triacrylformal and 0.021 g/m² of wetting agent F₁₅C₇-COONH₄.

The thus obtained element was dried and subjected to a temperature of 40°C for 5 days and then the emulsion layer was overcoated with a layer containing PdS as physical development nuclei, hydroquinone at 0.4g/m² and formaldehyde at 100mg/m².

The following processing solutions were prepared :

| Activator | |
|---|---|
| sodium hydroxide (g) | 30 |
| sodium sulphite anh. (g) | 35 |
| compound 3 of table 1 (g) | 1.1 |
| 2-aminoethyl-aminoethanol (ml) 2-mercapto-5-n.heptyl- | 30 |
| oxa-3,4-diazole (mg) | 225 |
| water to make | 1 l |

| Neutralization solutions | A | B | C | D |
|---|---|---|---|---|
| NaH₂PO₄.2H₂O (mole) | 0.4 | 0 | 0 | 0 |
| Na₂HPO₄.12H₂O (mole.10⁻²) | 2 | 0 | 0 | 0 |
| sodium sulphite anh. (g) | 5 | 0 | 0 | 0 |
| phenol (mg) | 50 | 0 | 0 | 0 |
| cysteine (g) | 1 | 0 | 0 | 0 |
| Triethanolamine (mole) | 0 | 0.3 | 0 | 0 |
| Diethanolamine (mole) | 0 | 0 | 0.41 | 0 |
| THA ** | 0 | 0 | 0 | 0.36 |
| Nitric acid 10.3 N (ml) | 0 | 26.2 | 0 | 0 |
| Sulfuric acid 6 N (ml) | 0 | 0 | 63.5 | 54 |
| water to make | 11 | id | id | id |
| pH | 5.7 | 5.6 | 7.0 | id |

| | | | | |
|---|---|---|---|---|
| ** THA: Tri-(2-hydroxypropyl)amine | | | | |

| Dampening solution | |
|---|---|
| water | 880 ml |
| citric acid | 6 g |
| boric acid | 8.4 g |
| sodium sulphate anh. | 25 g |
| ethyleneglycol | 100 g |
| colloidal silica | 28 g |

Five imaging elements prepared as described above were each image-wise exposed, processed with the above described activator for 30 s at 20 °C and subsequently neutralized at 25 °C with one of the neutralization solution A-D as described above and dried.

The printing plates thus prepared were mounted on the same offset printing machine HEIDELBERG GTO-52, marketed by Heidelberg, A.G., Germany, equipped with a DAHLGREN " 3-roll " dampening system, and were used for printing under identical conditions. The above mentioned dampening solution was used at a 3 % concentration in an aqueous solution containing 10 % isopropanol as fountain solution. The ink used was VAN SON RUBBERBASE RB 2329, marketed by Van Son, Royal Dutch Ink Factories, Hilversum, The Netherlands. A compressible rubber blanket was used.

The plates were evaluated for the number of copies that had to be disposed of at the start of the printing process because of poor quality, mainly ink acceptance in the non-printing areas. It was found that the number of useless copies in case the comparative neutralizing solution A was used, was 200 whereas in case one of the four neutralizing solutions in accordance with the present invention B, C, or D were used the number was about 50.

## Claims

1. A method for making a lithographic printing plate according to the silver salt diffusion transfer process comprising the steps of:
- image-wise exposing an imaging element comprising on a support a photosensitive layer comprising a silver halide emulsion and an image receiving layer containing physical development nuclei in water permeable relationship with said emulsion layer,
- developing said imaging element in the presence of developing agent(s) and silver halide solvent(s) using an alkaline processing solution and
- treating the thus obtained developed imaging element using a neutralizing solution having a pH at 25 °C between 5 and 10.5,
characterized in that said neutralizing solution contains in a total concentration between 0.03 and 3 mole/l an alkanolamines that corresponds to the following formula: 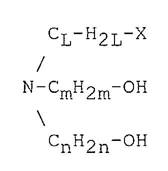 wherein X represents a hydrogen, a hydroxyl group or an amino group, L represents 0 or an integer from 1 to 4, m and n each independently represent an integer from 1 to 4.

2. A method according to claim 1 wherein the total concentration of said compounds in the neutralization solution is comprised between 0.1 mole/l and 1 mole/l.

3. A method according to claim 1 or 2 wherein the neutralization solution comprises a buffer.

4. A method according to any of claims 1 to 3 wherein the ph of a fresh neutralization solution lies between 6 and 8.

5. A method according to any of claims 1 to 4 wherein said neutralizing solution further comprises a heterocyclic compound, substituted by a mercapto or a thione group.

6. A method according to any of claims 1 to 5 wherein said alkaline processing solution comprises a meso-ionic compound.

## Patentansprüche

1. Ein Verfahren zur Herstellung einer lithografischen Druckplatte nach dem Silbersalz-Diffusionsübertragungsverfahren, das die folgenden Stufen umfaßt :
- die bildmäßige Belichtung eines bilderzeugenden Elements, das auf einem Träger eine fotoempfindliche Schicht enthält, die eine Silberhalogenidemulsion und eine physikalische Entwicklungskeime enthaltende Bildempfangsschicht in wasserdurchlässiger Beziehung zu dieser Emulsionsschicht umfaßt,
- die Entwicklung dieses bilderzeugenden Elements in Gegenwart von einer oder mehreren Entwicklersubstanzen und einem oder mehreren Silberhalogenid-Lösungsmitteln unter Verwendung einer alkalischen Verarbeitungsflüssigkeit, und
- die Behandlung des so erhaltenen entwickelten bilderzeugenden Elements unter Verwendung einer Neutralisationslösung mit einem pH-Wert zwischen 5 und 10,5 bei 25°C, dadurch gekennzeichnet, daß diese Neutralisationslösung in einem Gesamtverhältnis zwischen 0,03 und 3 Mol/l ein Alkanolamin entsprechend der folgenden Formel enthält : 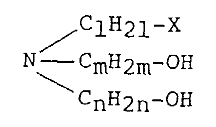 in der X ein Wasserstoffatom, eine Hydroxylgruppe oder eine Aminogruppe, L 0 oder eine ganze Zahl zwischen 1 und 4, und m und n jeweils unabhängig voneinander eine ganze Zahl zwischen 1 und 4 bedeutet.

2. Verfahren nach Anspruch 1, dadurch gekennzeichnet, daß das Gesamtverhältnis der Verbindungen in der NeutralisationsLösung zwischen 0,1 Mol/l und 1 Mol/l liegt.

3. Verfahren nach Anspruch 1 oder 2, dadurch gekennzeichnet, daß die Neutralisationslösung einen Puffer enthält.

4. Verfahren nach irgendeinem der Ansprüche 1 bis 3, dadurch gekennzeichnet, daß der pH einer frischen Neutralisationslösung zwischen 6 und 8 liegt.

5. Verfahren nach irgendeinem der Ansprüche 1 bis 4, dadurch gekennzeichnet, daß die Neutralisationslösung weiterhin eine heterocyclische, durch eine Mercaptogruppe oder Thiongruppe substituierte Verbindung enthält.

6. Verfahren nach irgendeinem der Ansprüche 1 bis 5, dadurch gekennzeichnet, daß die alkalische Verarbeitungslösung eine meso-ionische Verbindung enthält.

## Revendications

1. Procédé pour préparer un cliché d'impression lithographique conformément au procédé de transfert de sels d'argent par diffusion, comprenant les étapes consistant à:
- exposer en forme d'image un élément formateur d'image comprenant, sur un support, une couche photosensible comprenant une émulsion à l'halogénure d'argent et une couche réceptrice d'image contenant des germes de développement physique en relation de perméabilité à l'eau avec ladite couche d'émulsion,
- développer ledit élément formateur d'image en présence d'un ou de plusieurs agents développateurs et d'un ou de plusieurs solvants de l'halogénure d'argent en utilisant une solution de traitement alcaline, et
- traiter l'élément formateur d'image développé ainsi obtenu en utilisant une solution de neutralisation possédant un pH à 25°C entre 5 et 10,5, caractérisé en ce que ladite solution de neutralisation contient, en une concentration totale entre 0,03 et 3 moles/l, une alcanolamine qui répond à la formule ci-après: 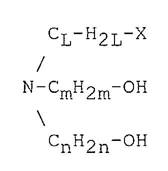 dans laquelle X représente un atome d'hydrogène, un groupe hydroxyle ou un groupe amino, L représente 0 ou encore un entier de 1 à 4, m et n représentent chacun, indépendamment l'un de l'autre, un entier de 1 à 4.

2. Procédé selon la revendication 1, dans lequel la concentration totale desdits composés dans la solution de neutralisation est comprise entre 0,1 mole/l et 1 mole/l.

3. Procédé selon la revendication 1 ou 2, dans lequel la solution de neutralisation comprend un tampon.

4. Procédé selon l'une quelconque des revendications 1 à 3, dans lequel le pH d'une solution de neutralisation fraîche se situe entre 6 et 8.

5. Procédé selon l'une quelconque des revendications 1 à 4, dans lequel ladite solution de neutralisation comprend en outre un composé hétérocyclique substitué par un groupe mercapto ou par un groupe thione.

6. Procédé selon l'une quelconque des revendications 1 à 5, dans lequel ladite solution de traitement alcaline comprend un composé méso-ionique.
